# EUROPEAN PATENT APPLICATION

(11) **EP 2 492 952 A2**
(43) Date of publication of application: **29.08.2012**
(21) Application number: 11167413.1
(22) Date of filing: 25.05.2011
(51) Int. Cl.: H01L 21/02

(54) **Nitride based light emitting device with excellent crystallinity and brightness and method of manufacturing the same**

(30) Priority: 28.02.2011 KR 20110018226
(71) Applicant: Semi-Materials Co., Ltd, Seongnam-si, Gyeonggi-do 463-400 (KR); Park, Kun, Bundang-gu Sengnam-si, Gyeonggi-do 463-440 (KR)
(72) Inventor: Jin, Joo, Gyeonggi-do 449-853 (KR); Park, Kun, Gyeonggi-do 463-440 (KR)
(74) Representative: Müller Schupfner & Partner

(57) **Abstract**

Disclosed is a nitride-based light emitting device having an inverse p-n structure in which a p-type nitride layer is first formed on a growth substrate. The light emitting device includes a growth substrate, a powder type seed layer for nitride growth formed on the growth substrate, a p-type nitride layer formed on the seed layer for nitride growth, a light emitting active layer formed on the p-type nitride layer, and an n-type ZnO layer formed on the light emitting active layer. The p-type nitride layer is first formed on the growth layer and the n-type ZnO layer having a relatively low growth temperature is then formed thereon instead of an n-type nitride layer, thereby providing excellent crystallinity and high brightness. A method of manufacturing the same is also disclosed.

## Description

### 1. Technical Field

The present invention relates to a technique for manufacturing a nitride-based light emitting device.

### 2. Description of the Related Art

A light emitting device is a semiconductor device based on a luminescence phenomenon occurring upon recombination of electrons and holes in the device.

For example, nitride-based light emitting devices such as GaN light emitting devices are widely used. The nitride-based light emitting devices can realize a variety of colors due to high band-gap energy thereof. Further, the nitride-based light emitting devices exhibit excellent thermal stability.

The nitride-based light emitting devices may be classified into a lateral type and a vertical type according to arrangement of an n-electrode and a p-electrode therein. The lateral type structure generally has a top-top arrangement of the n-electrode and the p-electrode and the vertical type structure generally has a top-bottom arrangement of the n-electrode and the p-electrode.

Generally, a nitride-based light emitting device includes a growth substrate, a buffer layer, an undoped nitride layer, an n-type nitride layer, a light emitting active layer, and a p-type nitride layer, which are formed sequentially from the bottom of the device.

The p-type nitride layer is finally grown in manufacture of the nitride-based light emitting device. Typically, it is known in the art that the p-type nitride layer is grown at a high temperature of 1000°C or more to ensure high crystal quality.

However, when the p-type nitride layer is formed at high temperature, there is a great influence on the light emitting active layer under the p-type nitride layer. In particular, there is a problem of a non-uniform composition due to evaporation of indium components and the like from the light emitting active layer. Accordingly, in a conventional light emitting device manufacturing method, the p-type nitride layer is grown at a relatively low temperature, causing deterioration in crystal quality.

### BRIEF SUMMARY

One aspect of the present invention is to provide a nitride-based light emitting device in which a p-type nitride layer is first formed on a growth substrate.

Another aspect of the present invention is to provide a method of manufacturing a nitride-based light emitting device, in which a p-type nitride layer is first formed on a growth substrate to improve crystal quality while minimizing influence on a light emitting active layer.

In accordance with one aspect of the invention, a nitride-based light emitting device includes: a growth substrate; a powder type seed layer for nitride growth formed on the growth substrate; a p-type nitride layer formed on the seed layer for nitride growth; a light emitting active layer formed on the p-type nitride layer; and an n-type ZnO layer formed on the light emitting active layer.

Here, the seed layer for nitride growth may be comprised of GaN powder. Alternatively, the seed layer for nitride growth may be comprised of sapphire powder. Alternatively, the seed layer for nitride growth may be comprised of silica powder.

The growth substrate may be a p-type silicon substrate.

In accordance with another aspect of the invention, a method of manufacturing a nitride-based light emitting device includes: forming a seed layer for nitride growth on a growth substrate using powder; forming a buffer layer on the seed layer for nitride growth; forming a p-type nitride layer on the seed layer for nitride growth; forming a light emitting active layer on the p-type nitride layer; and forming an n-type ZnO layer on the light emitting active layer.

### BRIEF DESCRIPTION OF THE DRAWINGS

The above and other aspects, features, and advantages of the invention will become apparent from the detailed description of the following embodiments in conjunction with the accompanying drawings:
Fig. 1 is a schematic sectional view of a nitride-based light emitting device according to an exemplary embodiment of the present invention;
Fig. 2 is a schematic sectional view of a nitride-based light emitting device, which includes a p-type silicon substrate as a growth substrate, according to an exemplary embodiment of the present invention; and
Fig. 3 is a schematic flowchart of a method of manufacturing the nitride-based light emitting device according to an exemplary embodiment of the present invention.

### DETAILED DESCRIPTION

Exemplary embodiments of the invention will now be described in detail with reference to the accompanying drawings.

It will be understood that when an element such as a layer, film, region or substrate is referred to as being "on" another element, it can be directly on the other element or intervening elements may also be present. In contrast, when an element is referred to as being "directly on" another element, there are no intervening elements present.

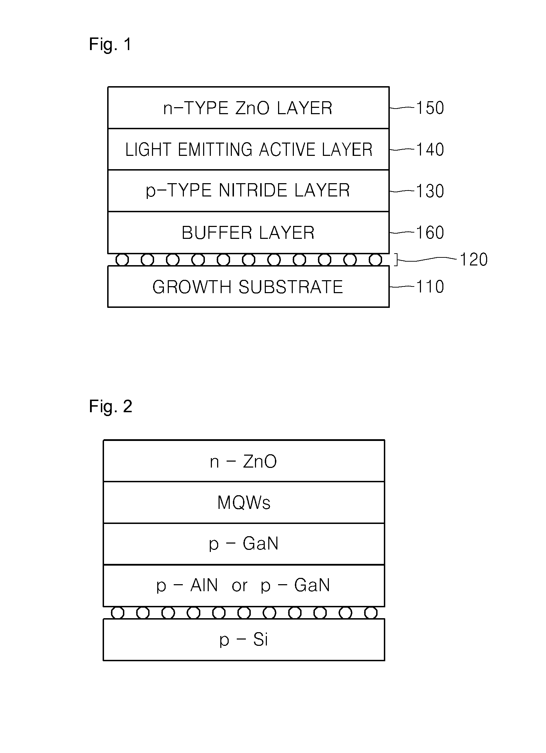

Fig. 1 is a schematic sectional view of a nitride-based light emitting device according to an exemplary embodiment of the present invention.

Referring to Fig. 1, the nitride-based light emitting device includes a growth substrate 110, a seed layer 120 for nitride growth, a p-type nitride layer 130, a light emitting active layer 140, and an n-type ZnO layer 150.

In this embodiment, the growth substrate 110 may be a sapphire substrate which is widely used as a growth substrate in manufacture of nitride-based light emitting devices. In addition, in this embodiment, the growth substrate 110 may be a silicon substrate such as a single crystal silicon substrate, a polycrystal silicon substrate, and the like.

The seed layer 120 for nitride growth is a powder type seed layer formed on the growth substrate 110 and acts as seeds for growth of a nitride layer. Herein, the term "powder type" refers to a material formed of powder.

Further, the seed layer 120 for nitride growth relieves lattice mismatch with respect to a nitride layer to be grown, thereby decreasing dislocation density during growth of the nitride layer.

For example, when a silicon substrate is used as the growth substrate, dislocation density increases to a great extent during growth of the nitride layer on the silicon substrate due to a great difference in lattice constant between the silicon substrate and the nitride layer, thereby causing deterioration in luminous efficacy of the light emitting device. However, when the seed layer for nitride growth is formed on the silicon substrate and the nitride layer is then formed on the seed layer for nitride growth, lattice mismatch between the nitride layer and the substrate is relieved, thereby reducing dislocation density caused by lattice mismatch during growth of the nitride layer

Such a seed layer 120 for nitride growth may be comprised of GaN powder, sapphire powder or silica powder, which can relieve lattice mismatch with respect to a nitride.

For example, when growing GaN powder on the GaN powder as the seed layer, lattice match can occur therebetween, thereby minimizing occurrence of dislocations during growth of a GaN layer. Further, when growing GaN on the GaN powder, the nitride layer is initially grown in the vertical direction and then grows in the horizontal direction, thereby enabling growth of a flat nitride layer.

The GaN, sapphire or silica powder may be attached or secured to the growth substrate 110 by spin coating, or the like.

To allow the powder to be easily attached or secured to the growth substrate 110, the growth substrate 110 may have an uneven surface formed with prominences and depressions. The surface unevenness may be formed as a specific or random pattern. The surface unevenness of the growth substrate 110 may be formed by various methods such as etching or the like.

When the growth substrate 110 has the uneven surface, the GaN, sapphire or silica powder may be easily attached or secured to the depressions of the uneven surface of the growth substrate 110.

The powder such as the GaN powder or the like applied to the seed layer for nitride growth may have an average particle size of 10 nm ∼ 1 µm. The smaller the average particle size of the powders, the better the effect of suppressing generation of dislocations during nitride growth. If the average particle size of the powder exceeds 1 µm, the effect of suppressing generation of dislocations is insufficient, causing low luminous efficacy of the manufactured nitride-based light emitting device. If the average particle size of the powder is less than 10 nm, manufacturing costs of the powder are excessively increased, thereby causing an increase in manufacturing costs of the nitride-based light emitting device.

Next, the p-type nitride layer 130 is formed on the seed layer 120 for nitride growth. The p-type nitride layer 130 is formed by doping a p-type impurity such as magnesium (Mg) and the like to ensure p-type electrical characteristics.

Conventionally, in the method of manufacturing a nitride-based light emitting device, the p-type nitride layer is formed at the last stage after the light emitting active layer is formed. Here, the p-type nitride layer is grown at a lower growth temperature to suppress influence of the p-type impurity on the light emitting active layer during formation of the p-type nitride layer. As a result, crystal quality of the p-type nitride layer is deteriorated, causing deterioration of light emitting efficiency.

In this embodiment, however, the p-type nitride layer 130 is formed before the light emitting active layer 140, thereby ensuring high crystal quality of the p-type nitride layer.

The light emitting active layer 140 is formed on the p-type nitride layer 130. The light emitting active layer 140 may have a multiple quantum well (MQW) structure. For example, the light emitting active layer 140 may have a structure having InₓGa₁₋ₓN (0.1≤x≤0.3) and GaN alternately stacked one above another or a structure having lnₓZn₁₋ₓO (0.1≤x≤0.3) and ZnO alternately stacked one above another.

In the light emitting active layer 140, electrons traveling through the n-type ZnO layer 150 recombine with holes traveling through the p-type nitride layer 130 to generate light.

The n-type ZnO layer 150 is formed on the light emitting active layer 140 and exhibits opposite electrical characteristics to those of the p-type nitride layer 130. Although ZnO is an n-type material, ZnO has insignificant electrical characteristics compared with those of the n-type layer formed using n-type impurities and may act merely as a current path. Thus, n-type impurities such as silicon (Si) may be doped into the n-type ZnO layer 150.

As described above, ZnO has a Wurtzite lattice structure that is substantially the same as that of GaN. In addition, since ZnO can be grown even at a temperature of about 700∼800°C, it is possible to improve crystal quality by minimizing influence on the light emitting active 140 during growth of ZnO. Thus, the n-type ZnO layer 150 applicable to the present invention can replace n-type GaN, which is grown at high temperature of about 1200°C.

Further, application of the n-type ZnO layer 150 results in further improvement of brightness as compared with the case where the n-type GaN layer is used.

As such, in the embodiment of the invention, the p-type nitride layer 130 is first formed on the growth substrate and the n-type ZnO layer 150 is then formed on the light emitting active layer.

Fig. 2 is a schematic sectional view of a nitride-based light emitting device, which includes a p-type silicon substrate as a growth substrate, according to an exemplary embodiment of the present invention.

As shown in Fig. 2, the nitride-based light emitting device according to the embodiment of the invention may employ the p-type silicon substrate as the growth substrate. When the p-type silicon substrate is adopted, p-type layers may be formed as the respective layers under the light emitting active layer. Further, when the p-type silicon substrate is adopted, the silicon substrate may act as a p-electrode, thereby eliminating a process of removing the substrate and a process of forming the p-electrode, even in manufacture of a vertical light emitting device.

Thus, when adopting the p-type silicon substrate, it is possible to easily fabricate not only the lateral type light emitting device but also the vertical type light emitting device which has a relatively wide light emitting area to easily realize emission of light with high brightness.

On the other hand, referring to Fig. 1, the light emitting structure may further include a buffer layer 160 between the seed layer 120 and the p-type nitride layer 130. The buffer layer 160 serves to relieve stress generated during growth of the nitride layer, which is a hetero-material, on the growth substrate. Such a buffer layer 160 may be comprised of a nitride material such as AIN, ZrN, GaN, or the like.

The buffer layer 160 may be a p-type buffer layer. Nitrides for the buffer layer 160 generally have high electric resistance. However, if the buffer layer 160 is the p-type buffer layer, the buffer layer has low electric resistance. Accordingly, it is possible to improve operational efficiency of the nitride-based light emitting device

Particularly, when the buffer layer 160 is the p-type layer and the p-type silicon substrate is used as the growth substrate 110, holes can easily move from the p-type silicon substrate to the light emitting active layer 140 without interference of a barrier, thereby further improving operational efficiency of the light emitting device.

In addition, when the buffer layer 160 is a p-type buffer layer, impurities such as magnesium (Mg) in the buffer layer 160 diffuse into the growth substrate 110. In this case, the substrate exhibits electrical characteristics of a p-type layer. Thus, even if a sapphire substrate having insulation characteristics is used as the growth substrate 110, there is no need to remove the sapphire substrate, unlike in manufacture of conventional vertical type light emitting devices.

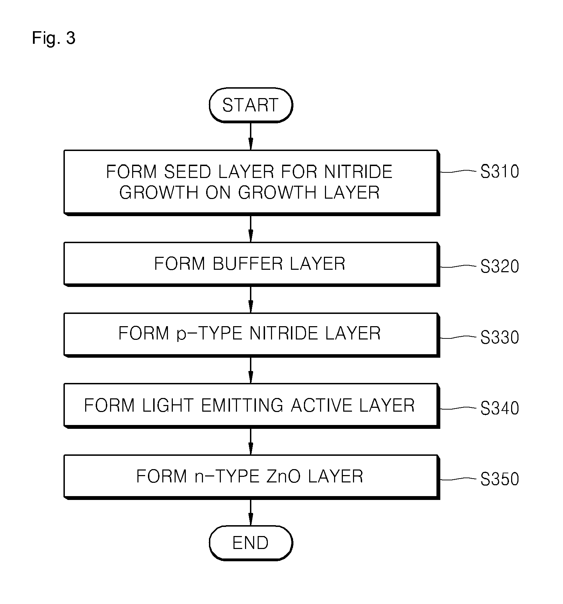

Fig. 3 is a schematic flowchart of a method of manufacturing the nitride-based light emitting device according to an exemplary embodiment of the present invention.

Referring to Fig. 3, the method of manufacturing a nitride-based light emitting device includes forming a seed layer for nitride growth in operation S310, forming a buffer layer in operation S320, forming a p-type nitride layer in operation S330, forming a light emitting active layer in operation S340, and forming an n-type ZnO layer in operation S350.

In operation S31 0, the seed layer for nitride growth is formed on a growth substrate such as a silicon substrate or a sapphire substrate

In this operation, the seed layer for nitride growth may be formed using GaN powder, sapphire powder or silica powder.

The seed layer for nitride growth may be formed using these powders according to the following method.

First, GaN powders or the like are coated on the growth substrate using a spin coater or the like. Then, the growth substrate is heated to about 800∼1200°C in an ammonia gas atmosphere in a chamber, for example a CVD chamber, such that the GaN powders are attached to the growth substrate. In this case, the growth substrate may be slightly etched to form an uneven surface. The surface unevenness of the growth substrate facilitates attachment or securing of the powders thereto.

Alternatively, the seed layer for nitride growth may be formed using a solution containing the GaN powders or the like by spin-coating the solution onto the growth substrate and drying the growth substrate. Here, the solution containing the GaN powders may be prepared using various solvents, such as acetone, methanol, ethylene glycol, and the like.

Either or both of the methods described above may be selectively used to form the seed layer for nitride growth. For example, the seed layer for nitride growth may be formed by spin-coating and drying the solution containing the GaN powders or the like on the growth substrate, followed by heating the growth substrate in a chamber.

Subsequently, a plurality of nitride layers is sequentially grown on the seed layer to form a light emitting structure through operation S320 of forming a buffer layer, operation S330 of forming a p-type nitride layer, and operation S340 of forming a light emitting active layer.

In operation S350, the n-type ZnO layer is grown on the light emitting active layer in an atmosphere of nitrogen (N₂), helium (He), oxygen (O₂), or the like at a low temperature of about 700∼800°C.

As set forth above, in the method of manufacturing a nitride-based light emitting device according to the embodiment, a p-type nitride layer is formed on a growth substrate, followed by forming an n-type ZnO layer, which can be grown at relatively low temperature, on a light emitting active layer. As a result, it is possible to improve crystal quality of the p-type nitride layer while minimizing influence on the light emitting active layer during growth of the n-type ZnO layer.

In addition, in the method of manufacturing a nitride-based light emitting device according to the embodiment, a seed layer for nitride growth is formed using GaN powder, sapphire powder or silica powder, thereby minimizing dislocation density caused by a difference in lattice constant between the silicon substrate and a nitride layer during growth of the nitride layer.

As such, in the method of manufacturing a nitride-based light emitting device according to the embodiments, first, a p-type nitride layer may be formed on a growth substrate, thereby improving crystal quality of the p-type nitride layer. In addition, according to the embodiments, since an n-type ZnO layer capable of being grown at relatively lower temperature is formed on a light emitting active layer, it is possible to reduce influence on the light emitting active layer.

Further, in the method according to the embodiments of the invention, GaN powder, sapphire powder or silica powder is used to form a seed layer for nitride growth, thereby minimizing dislocation defects caused by a difference in lattice constant between the nitride layer and the silicon substrate during growth of the nitride layer.

Further, in the method according to the embodiments of the invention, a p-type silicon substrate is used, thereby facilitating manufacture of a vertical type light emitting device without a process of removing a substrate.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. A nitride-based light emitting device including a light emitting active layer between a p-type nitride layer and an n-type ZnO layer, **characterized by** comprising:
a growth substrate;
a powder type seed layer for nitride growth formed on the growth substrate;
a p-type nitride layer formed on the seed layer for nitride growth;
a light emitting active layer formed on the p-type nitride layer; and
an n-type ZnO layer formed on the light emitting active layer.

2. The nitride-based light emitting device of claim 1, **characterized in that** the seed layer for nitride growth is comprised of GaN powder.

3. The nitride-based light emitting device of claim 1, **characterized in that** the seed layer for nitride growth is comprised of sapphire powder.

4. The nitride-based light emitting device of claim 1, **characterized in that** the seed layer for nitride growth is comprised of silica powder.

5. The nitride-based light emitting device of claim 1, **characterized in that** the growth substrate is a silicon substrate or a sapphire substrate.

6. The nitride-based light emitting device of claim 1, **characterized in that** the growth substrate is a p-type silicon substrate.

7. The nitride-based light emitting device of claim 1, **characterized in that** the growth substrate has an uneven surface.

8. The nitride-based light emitting device of claim 1, further comprising: a nitride buffer layer between the seed layer for nitride growth and the p-type nitride layer.

9. The nitride-based light emitting device of claim 8, **characterized in that** the buffer layer is comprised of a p-type nitride.

10. A method of manufacturing a nitride-based light emitting device including a light emitting active layer between a p-type nitride layer and an n-type ZnO layer, **characterized by** comprising:
forming a seed layer for nitride growth on a growth substrate using powder;
forming a buffer layer on the seed layer for nitride growth;
forming a p-type nitride layer on the seed layer for nitride growth;
forming a light emitting active layer on the p-type nitride layer; and
forming an n-type ZnO layer on the light emitting active layer.

11. The method of claim 10, **characterized in that** the seed layer for nitride growth is comprised of GaN powder.

12. The method of claim 10, **characterized in that** the seed layer for nitride growth is comprised of sapphire powder.

13. The method of claim 10, **characterized in that** the seed layer for nitride growth is comprised of silica powder.

14. The method of claim 10, **characterized in that** the forming the seed layer for nitride growth comprises placing the powder on the growth substrate and heating the growth substrate such that the powders are attached to the growth substrate.

15. The method of claim 10, **characterized in that** the forming the seed layer for nitride growth comprises coating a solution containing the powder onto the growth substrate using a spin coater, and drying the growth substrate.
